(19) Europäisches Patentamt
European Patent Office
Office européen des brevets

(11) **EP 1 048 109 B1**

(12) **EUROPEAN PATENT SPECIFICATION**

(45) Date of publication and mention
of the grant of the patent:
**22.04.2009 Bulletin 2009/17**

(51) Int Cl.:
*H03K 19/0175* (2006.01)    *H03K 19/0185* (2006.01)
*H03K 19/003* (2006.01)

(21) Application number: **98942306.6**

(22) Date of filing: **27.08.1998**

(86) International application number:
**PCT/US1998/017942**

(87) International publication number:
**WO 1999/010982 (04.03.1999 Gazette 1999/09)**

(54) **CURRENT CONTROL TECHNIQUE**

STROMSTEUERUNGSTECHNIK

TECHNIQUE DE COMMANDE DE COURANT

(84) Designated Contracting States:
**DE FR GB IT NL**

(30) Priority: **29.08.1997 US 57400 P**
         **02.02.1998 US 73353 P**

(43) Date of publication of application:
**02.11.2000 Bulletin 2000/44**

(60) Divisional application:
**06020077.1 / 1 821 409**

(73) Proprietor: **RAMBUS INC.**
**Los Altos,**
**California 94022 (US)**

(72) Inventors:
• **GARRETT, Billy, Wayne, Jr.**
**Mountain View, CA 94043 (US)**
• **DILLON, John, B.**
**Palo Alto, CA 94036 (US)**
• **CHING, Michael, Tak-Kei**
**Sunnyvale, CA 94086 (US)**
• **STONECYPHER, William, F.**
**San Jose, CA 95118 (US)**
• **CHAN, Andy, Peng-Pui**
**San Jose, CA 95132 (US)**
• **GRIFFIN, Matthew, M.**
**Mountain View, CA 94043 (US)**

(74) Representative: **Eisenführ, Speiser & Partner**
**Patentanwälte Rechtsanwälte**
**Postfach 10 60 78**
**28060 Bremen (DE)**

(56) References cited:
| | |
|---|---|
| **US-A- 4 860 198** | **US-A- 5 107 230** |
| **US-A- 5 134 311** | **US-A- 5 194 765** |
| **US-A- 5 254 883** | **US-A- 5 546 042** |

## Description

### Background of the Invention

### Field of the Invention

The present invention relates to the field of integrated circuits and high-speed buses. More specifically, the present invention relates to a circuit for a high-speed driver and techniques for obtaining rapid switching speed with low power consumption and low noise on high-speed buses.

### Description of the Related Art

To obtain rapid switching speed on a bus with low power consumption and low noise, it is desirable for a current mode driver to set and control the current at which the driver operates. U.S. Patent 5,254,883, assigned to the assignee of the present invention, discusses an apparatus and method for setting and maintaining the operating current of a current mode driver for a bus. Essentially, for a bus with a master-slave architecture, there are two problems to be solved in setting the operating current on the bus. First, the operating current of the master's current mode drivers should be properly set. Second, the operating current of the slave's current mode drivers should be properly set. Once these currents are set, they are maintained at those settings despite process, voltage and temperature variations by circuitry in the master and slave devices.

A master-slave bus architecture is discussed in the '883 patent in which a master may send data to and receive data from a slave. A slave may send data to and receive data from a master, but not another slave. The master sets its operating current for its drivers and each slave sets the operating current for its drivers.

The master employs an adjustable current sink as a driver for each bus line that it drives. The current sink turns on to drive the voltage on the bus line, $V_{out}$, to a voltage closer to ground and turns off to allow a termination resistor, $R_{term}$, on the bus line to pull the bus line closer to the terminator voltage, $V_{term}$. The current in the driver, $I_d$, is set by a digital counter whose count is determined from a feedback circuit having a comparator. If the count is all zeros then no current flows in the driver and the voltage on the bus line, $V_{out}$, is the termination voltage, $V_{term}$. If the count is all ones, then the maximum current flows in the driver and the voltage on the bus line,

$$V_{out}, \text{ equals } V_{term} - I_d * R_{term}.$$

The feedback circuit compares a voltage reference, $V_{ref}$, to a node voltage, $V_n$, derived from a scaled reference driver which receives the count from the counter. Feedback assures that the node voltage matches the reference voltage, $V_n = V_{ref}$. When the match occurs the reference driver has an output swing (i.e., change in voltage) of ($V_{term} - V_{ref}$) and the actual output driver has a swing of $2 * (V_{term} - V_{ref})$ due to the scaling between the reference driver and the actual output driver. Therefore, $V_{out}$ equals ($V_{term} - 2) * (V_{term} - V_{ref})$. Thus, by selecting a value for $V_{term}$ and $V_{ref}$ any size symmetric voltage swing about $V_{ref}$ may be achieved.

The slave in the '883 patent also employs an adjustable current sink as a driver for each bus line that it drives. A counter similarly controls the value of the current in the driver such that the driver may swing between $V_{term}$ and $V_{term} - I_d * R_{term}$, where $I_d$ is the current setting in the driver of the slave. However, the value in the counter is directly proportional to the value of an RC time constant whose capacitance, C, is set by the master. The master also determines whether the value of $V_{out}$ from the driver matches $V_{ref}$ in the master. It adjusts the RC time constant so that the count in the counter will set a current in the driver and $V_{out}$ will match $V_{ref}$. Thus $V_{out}$ will equal $V_{term} - (V_{term} - V_{ref})$. In order to produce a symmetric swing about $V_{ref}$ another step is required. The master should double the value of the RC time constant which will double the count. This will produce a $V_{out}$, which is equal to $V_{term} - 2 * (V_{term} - V_{ref})$.

Maintenance of the current setting of the driver in the slave may be performed in a manner different from that in the master. In the slave, the effective R in the RC time constant is derived from a reference voltage and reference current. If due to variations in temperature or supply voltage, the reference current decreases then the effective R in the RC time constant increases. This increases the count and the operational current setting of the driver in the slave, thus compensating, for the effect. If the reference current increases, the effective R and the count decrease, again compensating for the change.

While the above techniques of setting and maintaining operating current in the master and slave bus line drives have met with substantial success, the techniques are not without certain shortcomings. For example, the technique of setting the current in the master requires an extra pin dedicated to receive the external resistor. Another shortcoming is selecting the proper value of the external resistor to maintain the factor of two scaling between ($V_{term} - V_n$) and ($V_{term} - V_{out}$). If the scaling is not precisely set, the output swing is not symmetric about $V_{ref}$. Further, as process, voltage, or temperature variations occur, the value selected for the resistor may not be ideal. A further shortcoming is that an electrostatic discharge structure (ESD) in series with the pin receiving the external resistor adds a variable amount of resistance in series with the external resistor. This makes the selection of the external resistance subject to variations in the ESD structure.

Further, a shortcoming in the technique of setting the current in the slave is that a relatively complex algorithm between the slave and the master is required to correctly set the current in the slave. The master sets the RC time constant which in turn determines the count and the output value. The master then tests the output value to determine whether it matches $V_{ref}$. If not, it increases the count and retests the output value. This cycle continues until a match occurs. However, a match of $V_{out}$ to $V_{ref}$ for one bus line, does not always insure that a match will occur on another bus line due to small differences in characteristics between output drivers, bus lines, and $V_{ref}$ comparison circuits.

As can be seen, an improved output driver circuit and techniques for obtaining rapid switching speed with low power consumption and low noise is needed.

Summary of the Invention

The present invention includes a circuit and current control technique to enable high-speed buses with low noise. This circuitry may be used in the interfacing of high-speed dynamic RAMs (DRAMs). The architecture of the present invention includes the following components: an input isolation block (Isolation), an analog voltage divider (AVD), an input comparator, a sampling latch, a current control counter, and a bitwise output driver (output driver A and output driver B).

A fundamental operation of the current control mechanism is to evaluate the voltage levels $V_{hi}$, $V_{low}$, and $V_{ref}$, and increment or decrement the current control counter accordingly to set an appropriate output level. When the current control circuitry is in an evaluation mode, output driver A is off (not sinking current), and node BDA is at the output high voltage level (typically $V_{term}$). Output driver B is active, and pulls node BDB to the low voltage output level. The voltage levels at nodes BDA and BDB are passed through the isolation block, and fed into the analog voltage divider. The analog voltage divider outputs a voltage level which is a weighted average of it's input. *I.e.*, $V_{out} = (A* V_{hi}) + (B * V_{low})$. For example, in a specific case, $V_{out} = (0.5 * V_{hi}) + (0.5 * V_{low})$.

The input comparator compares $V_{out}$ and $V_{ref}$ and generates an up signal. The up signal is sampled, and used to increment or decrement the current control value held in the current control counter. By repeating this process the current control value will settle to a value where $Vol = (V_{ref} - A * V_{term})/B$.

When the current control circuity is not active, the input isolation block shields any interactions of the analog voltage divider circuitry and the output pad.

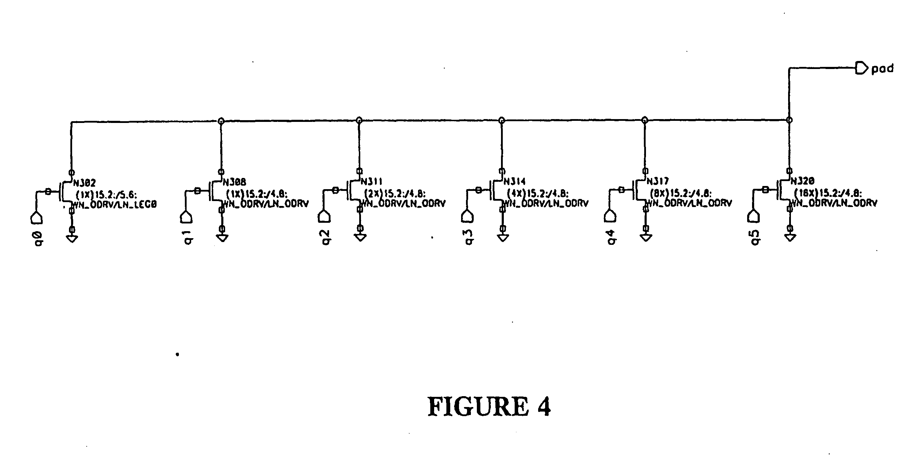

The output driver is composed of a series of individual output transistors, an example of which is shown in Figure 4. The number of active output transistor blocks are selected with control signal ictrl[n:O]. The width of the output devices may be scaled in a geometric fashion to allow encoding of the ictrl[n:O] signal.

The input isolation gates may be implemented as CMOS pass gates, NMOS passgates with boosted gate voltages, unity gain buffers, or operational amplifiers (op amps). The analog voltage divider may be implemented with a resistor divider, a digital-to-analog converter, or switched capacitor filter such as a sigma/delta modulator. The sampling latch may be implemented as a simple flip-flop or latch, or a series of sequential elements with logic to average the sampled value. The current control counter may be implemented as an up-down counter or a more sophisticated counter such as a saturating binary search counter.

Other objects, features, and advantages of the present invention will become apparent upon consideration of the following detailed description and the accompanying drawings, in which like reference designations represent like features throughout the figures.

Brief Description of the Drawing

Fig. 1 illustrates a prior art implementation of a current control circuit having a master device and slave device;

Fig. 2 shows a block diagram of current control circuitry in accordance with an embodiment of the present invention;

Fig. 3 illustrates current control circuitry in accordance with an embodiment of the present invention;

Fig. 4 illustrates an output driver which may be utilized in accordance with an embodiment of the invention;

Fig. 5 is a detailed illustration of an implementation of the current control circuitry of the invention;

Fig. 6 shows circuitry for the gxCCbst1 element of Fig. 5, which may be used to generate a boosted voltage;

Fig. 7 shows circuitry for an input comparator gxCComp of Fig. 5;

Fig. 8 shows a resistor divider implementation for gxCCDiv0 of Fig. 5; and

Fig. 9 shows a resistor divider implementation for gxCCDiv1 of Fig. 5.

Fig. 10 illustrates control and test mode logic circuitry that may be used in accordance with an embodiment of the invention.

Fig. 11 illustrates a current control counter circuit that may be used in accordance with an embodiment of the invention.

Description of the Preferred Embodiments

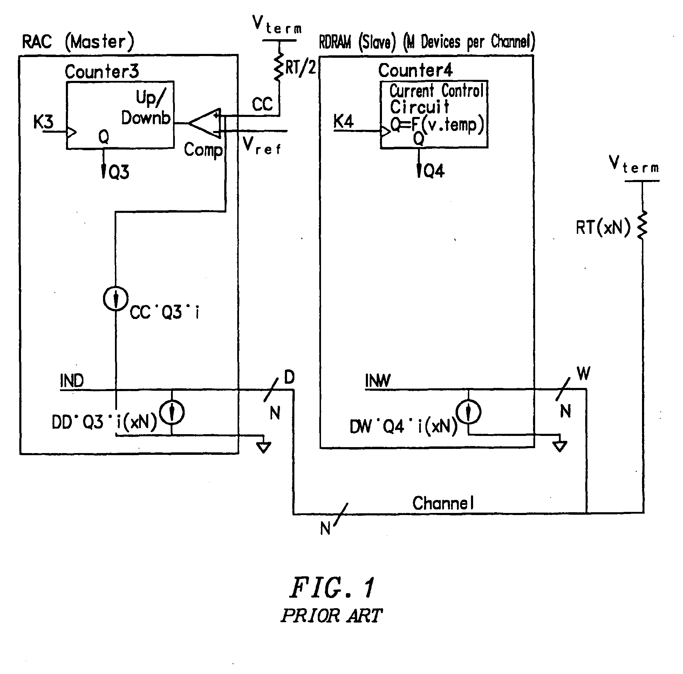

The present invention provides an improved apparatus and method of setting the current in master and slave devices connected to a common bus. Figure 1 is a block diagram of a current control implementation with a master device (RAC) and a slave device (RDRAM), in accordance with the prior art. Figure 1 is simplified to display only a single slave device RDRAM, however it should be appreciated that many slave devices may be used in connection with the master device RAC.

In accordance with the prior art, the master device RAC has a dedicated output pin CC. The output pin CC is connected to a termination voltage $V_{term}$ through a resistor $R_{term}/2$. If the output driver is an ideal current source, then the voltage output will be the middle of the swing. This value is compared to $V_{ref}$ and adjusted up or down accordingly.

For the slave device RDRAM, there is a circuit that indirectly infers the amount to adjust the output current depending on variations of voltage and temperature. The original proper value is established by running a current control initialization routine which requires reading data back through the master device and detecting the first time valid ones are transmitted on the bus. This threshold is discovered and then doubled (approximately) before being sent to the slave device.

The technique shown in Figure 1 requires N + 1 pins on the master device, and N pins on the slave device. The additional pin on the master device is required for the CC connection shown in Figure 1. The device of Figure 1 also requires the resistor RT/2 on the printed circuit board upon which the master device is mounted. Unfortunately, the RT/2 resistor may not have the desired value. The current produced by the output transistor varies slightly as the voltage changes, which means there are non-ideal effects of the V-I characteristics of the output transistor, such as channel length modulation. So although it is desirable for the current control resistor to be $R_{term}/2$, its value is more likely about $R_{term}/2.2$. The value also varies somewhat due to differences in process, vendor, and temperature.

Internal to the master device RAC, there is an input comparator COMP. The comparator compares $V_{ref}$ to the voltage on the current control pin (CC). If the voltage comparison determines the output is too low, then a counter (Counter3) is incremented, thereby increasing the current of all the output drivers on the chip (during the next current control cycle). If the current is too high, then the counter (Counter3) is subsequently decreased. By selecting the proper resistor (which is difficult to do), the current control circuit adjusts the output drive at regular intervals to keep the full voltage swing of the remaining pins. This then tracks any drift of the transistors due to voltage or temperature effects, allows for different process variations chip to chip, and provides many similar benefits. However, selecting the proper resistor value to achieve this result is difficult.

A further technique involves using an expansion mechanism referred to as "y-channel." However, this technique requires that the resistor value be changed (essentially halved) when the module is inserted, compared to the case when it is not inserted. This may be achieved by adding a parallel current control resistor to the one on the motherboard which essentially changes the parallel resistance so that the output current is doubled. Unfortunately, the nonlinear nature of the transistors again requires that a "special" resistor value be calculated in order to double the current. Once the proper resistor value is found, automatic tracking is still assured using the expansion mechanism.

A consideration that needs to be addressed for some integrated circuits is that an electrostatic discharge (ESD) structure may be placed in series with the current control pin. This adds a variable amount of resistance, significant enough to change the needed external resistor value substantially. The resistance of such an ESD structure needs to be accounted for.

As known in the art, current control calibrations are performed during "quiet" times on the bus. That is, the current control calibrations are "scheduled" between activities on the bus.

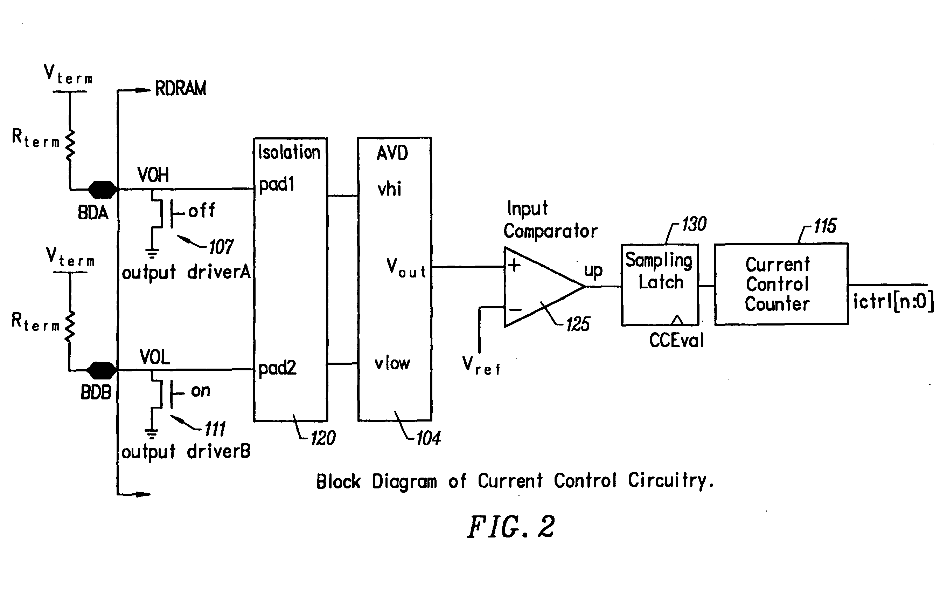

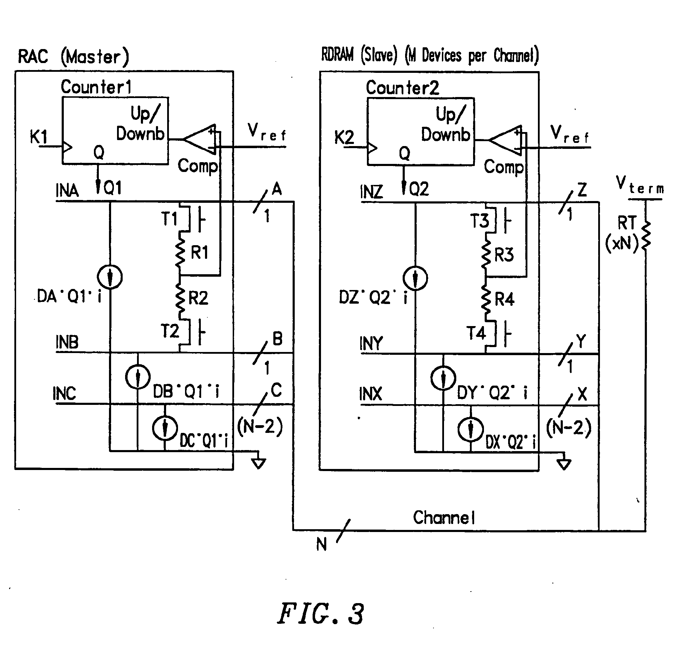

Figure 2 shows an overall diagram of an embodiment of the current control technique of the present invention. Figure 3 is a schematic of the architecture utilized in accordance with the invention. Figures 4-8 show circuit schematics of a specific implementation of the present invention.

The circuit of Figure 2 includes the following components: an input isolation block (Isolation) 120, an analog voltage divider (AVD) 104, an input comparator 125, a sampling latch 130, a current control counter 115, and a bitwise output driver (output driver A 107 and output driver B 111).

As shown in connection with Figure 1, the prior art relied upon an input comparator COMP in performing its current control functions. The present invention also uses an input comparator 125 for current control functions. However, unlike the prior art which received a control voltage from a dedicated external pin connected to a printed circuit board mounted resistor RT/2, the present invention uses a simple R over R resistive divider placed between an active output and a nonactive output. The output of the divider circuit is a voltage equal to ($V_{term}$ - $V_{swing}$)/2. This is exactly the value desired to compare against $V_{ref}$. It is desirable that these two are equal. If they are not, the current control circuit increments or decrements the counter and tracks any output current variations due to changes in current drive of the transistors (because of temperature or VDD changes).

The circuitry employs voltage divider circuitry 104 on both the master and slave devices. As shown in Figure 2, the voltage divider circuitry is connected between bus drivers A and B, driver 107 and 111, respectively. This circuitry is activated when the operating current must be set in the bus drivers and deactivated when the bus drivers are used in normal operation.

Bus lines connected to the two selected drivers of the master are different from bus lines connected to the two selected drivers of the slave device. Consequently, the setting of an operating value of current in the master can proceed simultaneously with the setting of a value in the slave. If there are multiple slaves, each slave device may use bus drivers connected to a unique pair of bus lines so that the setting of the operating current in the several slaves may proceed concurrently. Preferably, all slave devices use the same pins.

A counter (e.g., 115) in the master and in the slave determines the value of the current in the current driver as discussed above. The count in the master and slave is determined by a feedback circuit which compares a voltage reference, $V_{ref}$, to a common node voltage, $V_{out}$, which is derived from the voltage divider circuitry. The feedback circuit assures, via the counter, that $V_{ref}$ is equal to $[V_{term} - (V_{term} - V_{out})/(1+\text{voltage divider ratio})]$ by adjusting current in a selected one of the drivers to which the voltage divider circuitry is connected. One of the drivers is left in the off condition, providing $V_{term}$ to the voltage divider. Thus, the common mode voltage swings a fixed amount equal to $(V_{term} - V_{ref})$ which is applied across the upper one of the resistors, R1 (Figure 3), of the voltage divider when a resistive voltage divider is used. The lower one of the resistors, R2 (Figure 3), has $g*(V_{term} - V_{ref})$ across it, where g is the voltage divider ratio. *I.e.,* g = R2/R1 where R1 is connected between the off driver and the center node and R2 is connected between the center node and the on driver. Typical values for R1 and R2 are approximately 10K ohms. Thus, $V_{out}$ equals $(1+g)*V_{ref} - g*V_{term}$. If the resistors are equal then g equals one and $V_{out}$ equals $2*V_{ref} - V_{term}$. For example, if $V_{term}$ is 1.8 volts and $V_{ref}$ is 1.4 volts, then $V_{out}$ is 1.0 volts and the swing, $V_{swing}$, of $V_{out}$ is 0.8 volts. Also, the current in the output driver is now $V_{swing}/R_{term}$, which equals 0.8 volts/ 28 = 28.6 milliamps. For example, $R_{term}$ may be about 28 ohms. Typically, $R_{term}$ may be in the range from about 20 ohms to about 50 ohms.

When the voltage divider circuit is activated, the circuit itself creates a source of voltage error, caused by the current that flows through the voltage divider circuit from $V_{term}$, through the termination resistor, through R1 and R2 and to the output driver which is in the on-state. This current causes the voltage of the driver in the off-state to be slightly less than $V_{term}$, say $e*V_{term}$, where e is a number close to one. Specifically, $e = I - [((V_{term} - V_{out}) N_{term}) * (R_{term}/(R1 + R2 + R_{term}))]$. This current also causes the voltage of the driver in the on-state to be slightly higher than $V_{out}$ also by the same error term, say $e*V_{term}$. Therefore, using the suggested resistor values, e=0.998882 and $V_{out}$=1.002, so $V_{out}$ has a 2 millivolt error.

The feedback circuit assures that the common node of the voltage divider is locked to $V_{ref}$, so that the drop across R1 is $(e*V_{term} - V_{ref})$. The voltage drop across R2 is $e*V_{term} - V_{ref}$. The output voltage, $V_{out}$, is $2*V_{ref} - e*V_{term}$. So the output voltage is slightly higher than its value in the absence of the voltage divider. $V_{swing}$ is now $(1+e) V_{term} - 2* V_{ref}$ and the current in the output driver is $V_{swing}/R_{term} + (V_{term} - e*V_{term})/R_{term} = 2*(V_{term} - V_{ref})/R_{term} = 30$ milliamps, as before. Thus, while the output voltage is altered slightly when the voltage divider circuit is activated, it does not affect the setting of current in the output driver or the counter value that controls that current.

Under ideal conditions the ratio of the resistors, g, is a precise value, such as unity. However, if some errors are present in the circuit, it is desirable to compensate for them by slightly altering the ratio. Some sources of error are currents into the comparator and hysteresis or offsets in the comparator. Another source of error is the circuitry used to activate the voltage divider circuitry, if the activation circuitry is in the form of pass gates in series with R1 and R2 of the voltage divider.

Alternatively, the error current that flows in the divider circuit may be negligible compared to the amount of current controlled by one half of the least significant bit of the counter, if the resistances in the divider can be made large enough. The value of $(V_{term} - e*V_{term})/R_{term}$ is approximately 0.15 milliamps. The amount of current flowing through the voltage divider is $[(V_{term}-V_{out})/(R1+R2+R_{term})]$ or typically about 0.04mA. Seven bits controlling 28.6 milliamps makes 1/2LSB equal to 0.11 milliamps.

Another reason for altering the ratio, g, is that the edge rate for a rising signal may be different from a falling signal on the output of the bus driver. Altering the voltage divider ratio so that the swing is not symmetric about $V_{ref}$ may be necessary to obtain the best noise margin for receiving the signal on the bus.

In one embodiment the relationship between the counter value and the current in the driver is linear. Such a driver uses binary weighted output transistor legs to adjust the current in single steps from 0 to $2^N$ where N is the number of current control bits. In other embodiments there are other relationships between the counter value and current in the driver. For example, a logarithmic relationship can be used. This allows more precision with smaller count values and less precision with larger count values.

In another embodiment, the counter counts up until the proper current is reached. After the initial setting, the counter counts up or down to adjust the current in the driver. In another embodiment, more complex algorithms are employed to find the correct value for the count. One such algorithm is binary searching until a value close to the correct value is found and then counting up or down to obtain the precise value.

In a further embodiment, the feedback and counter circuit setting apply to all of the bus drivers of a device. In another embodiment there is a feedback and counter circuit for each or any number, 1-to-N, of the bus drivers of a device. This latter embodiment has the advantage that each driver is correctly set, but the disadvantage that more circuitry is required.

The setting of operating current in the bus driver can consume time on the bus, resulting in a loss of throughput. To eliminate this loss, in one embodiment, the setting of the current occurs during a period of time on the bus which cannot be used otherwise. If the slave devices are memory devices, that time is the time at which the memory devices are refreshed, which typically occurs every 16 microseconds for a duration of 80 ns. In some cases the setting of the operating current in the bus driver takes only about 20 ns, thus, the setting can occur concurrently with the refresh operation.

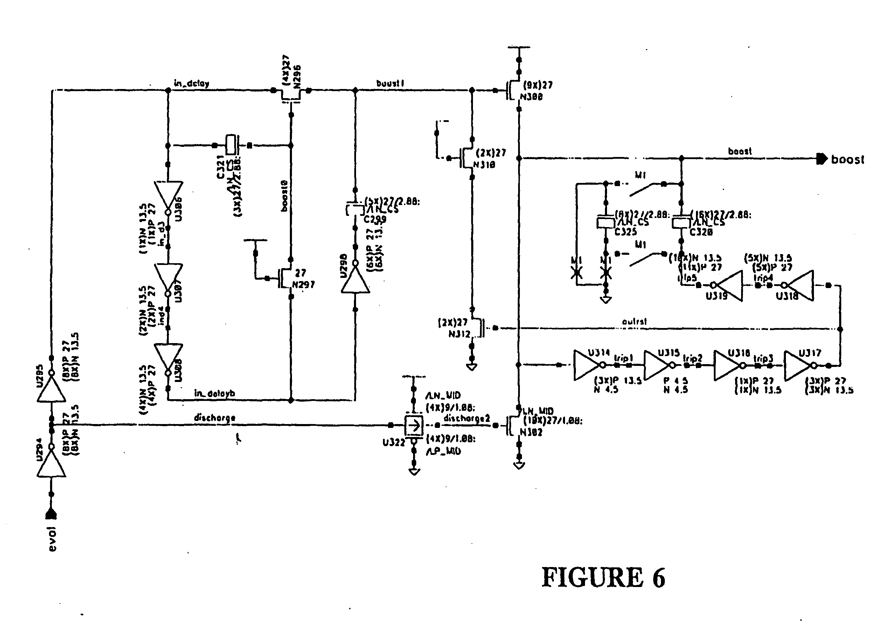

Connected to the voltage divider circuitry is a means for coupling the divider circuitry to the output lines to which it is attached. In one embodiment the means for coupling is simply a wire attached between the voltage divider circuitry and the output lines. In an alternate embodiment the means for coupling is composed of a CMOS pass gate which serves to isolate the voltage divider circuitry from the output lines to which it is attached when the current control circuitry is not enabled. In another embodiment the means of coupling is an NMOS pass gate with boosted gate voltages. A typical circuit to generate the boosted gate voltage level is shown in Figure 6.

Other embodiments employ unity gain buffers, operational amplifiers, transconductance, or sample-and-hold circuitry to couple the voltage at the output lines with the voltage divider. Still other embodiments employ capacitors to couple a difference voltage from the output lines to the voltage divider, such as in some switched capacitor filters.

While the above discussion referred to a resistance voltage divider, other embodiments for dividers include the use of digital to analog converters or switched capacitor filters such as a sigma/delta modulator. An analog-to-digital converter may be used to convert the analog input voltage and/or Vref values to a digital value. Subsequent division and comparison may then be performed by digital signal processing.

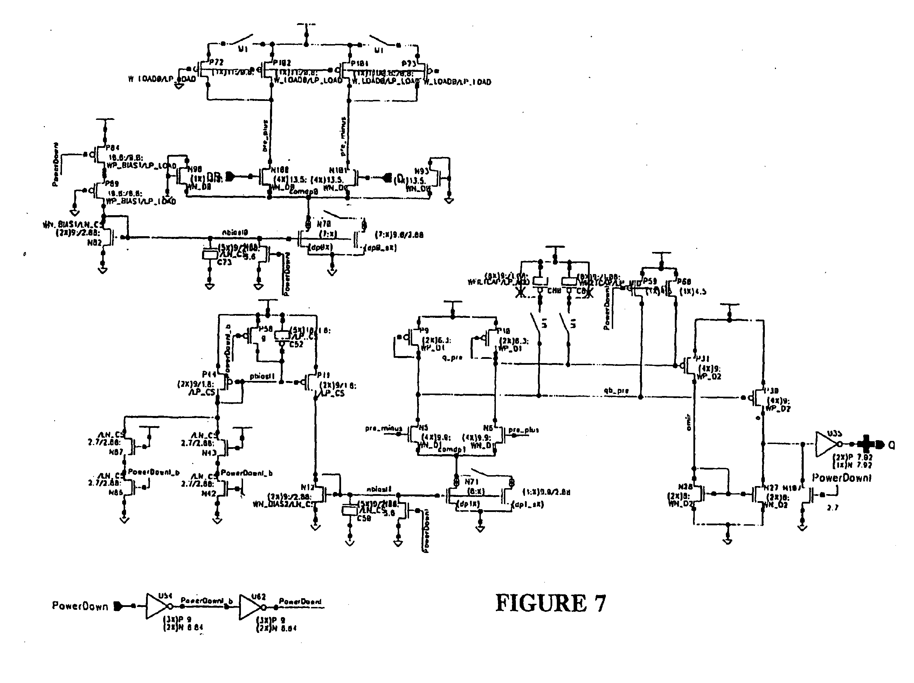

The output value from the voltage divider circuitry is compared to a voltage reference value. The comparator may be a simple analog differential voltage comparator shown in Figure 7. In an alternate embodiment, the comparator may be a regenerative sense-amp circuit. The comparator may also be a switched capacitor filter. In still another embodiment where an analog-to-digital converter is used as a voltage divider, the comparator may be a digital signal processor.

Preferably, the reference voltage is provided from an external pin. However, the reference voltage may also be generated with a band-gap reference circuit, or a voltage divider of Vdd or another voltage supply.

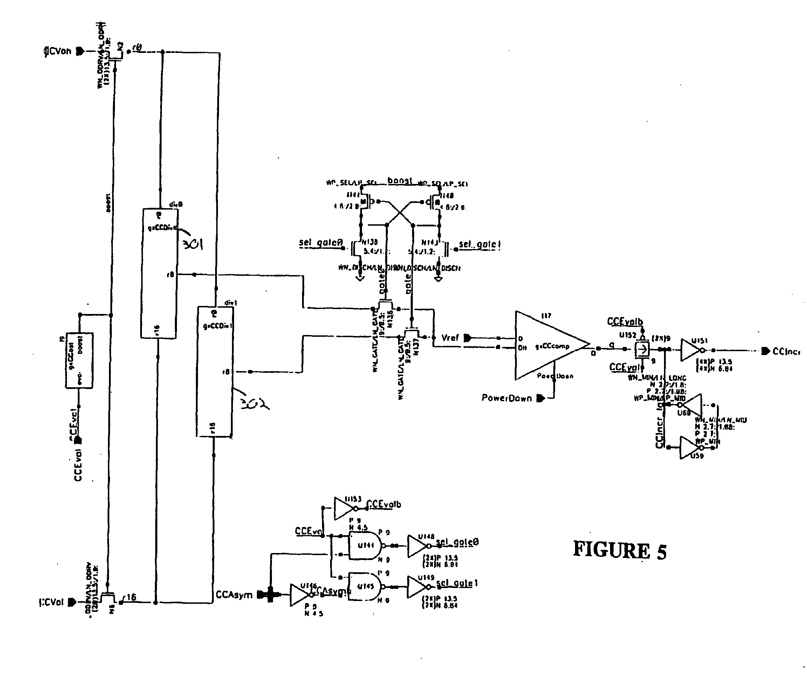

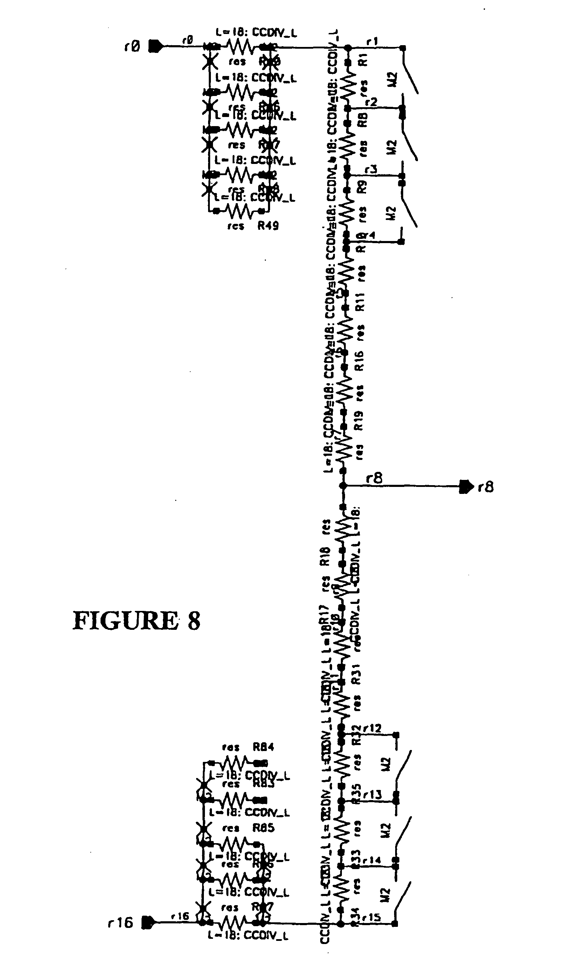

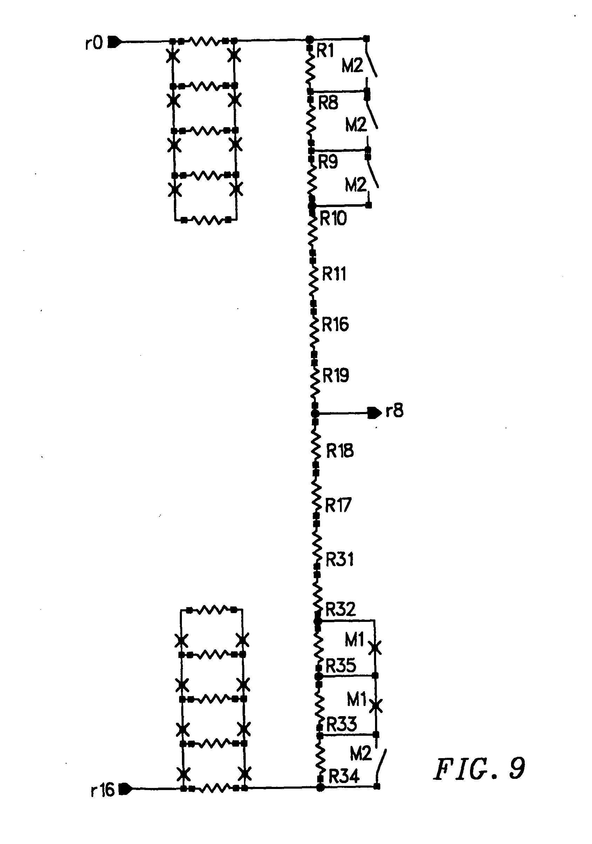

Preferably, two voltage divider ratios are selectable. For example, Figure 5 illustrates two voltage divider devices 301 and 302 that may be alternately selected. The actual voltage divider circuits may be implemented resistive ladders of the type shown in Figures 8 and 9.

In some embodiments, a sampling latch may be employed between the output of the comparator and the up-down counter. The sampling latch functions to average the output of the comparator so that the jitter on the counter is reduced.

The invention does not require the CC pin and external resistor shown in the prior art device of Figure 1. the invention also provides better tracking than the device of Figure 1. For Figure 1, a fairly complex, and somewhat unwieldy current control initialization algorithm is required to find the proper start value for each slave device. However, with the present invention, implementing the current control scheme eliminates the need for complex initialization as each slave device automatically adjusts its own output to proper swing levels. Slave devices are instructed on a regular but infrequent basis to check the outputs. This may be accomplished during the same time a master device performs its calibration.

For the master device, the benefits of the present invention include the elimination of the CC pin and output driver and greater accuracy of setting the proper current swing. Estimates show that by implementing the current control technique of Figure 2, an increase in voltage margin yields about 70MHz of additional timing margin.

Moreover, for the technique of the present invention, there is no need for current control resistors on y-channel modules. However, the technique is also backwards compatible for modules that currently have such resistors.

Furthermore, the slave device automatically adjust its swing and monitors the current to adjust for variations in output drive due to voltage and temperature variations. Also, each slave device finds its own current control value depending on the process variations of the individual component.

The benefits of the present invention for the slave device include better swing accuracy (related to a similar benefit for the master device), elimination of the existing current control tracking logic in the slave device, and elimination of the current control initialization routine described in U.S. Patent 5,254,883.

For the master device, two pins are used for current control adjustment. One pin is driven to a logic one (low voltage) and the other pin is not driven. The time this is done is under control of the control logic within the ASIC. The slave device is done at the same time, using different pins (for driving) than the master device is using. During this operation, a resistive divider is inserted between two pins, using pass transistors T1 and T2. These resistors halve the voltage between them and compare against the $V_{ref}$ voltage (already present on the chip). A counter is incremented if more current is needed to increase the voltage swing or decremented if too much voltage swing is detected. Although the digital adjustment is a simple up/down counter, a more sophisticated binary search can be implemented, followed by a simple adjust one up or down once the algorithm is completed. Such an embodiment is complicated, the savings of time to find the necessary set point may not justify elimination of a simple up/down counter.

For the slave device, two pins are used for current control adjustment. One pin is driven to a logic one (low voltage) and the other pin is not driven. This is done using a special register read command (or this could be done during a memory refresh to the same device). During this operation, a resistive divider is inserted between two pins, using pass transistors T3 and T4. These resistors halve the voltage between them and compare against the $V_{ref}$ voltage (already present on the chip). A counter is incremented if more current is needed to increase the voltage swing or decremented if too much voltage swing is detected. Although the digital adjustment is a simple up/down counter, a more sophisticated binary search could have been implemented, followed by a simple adjust one up or down once the algorithm is completed.

The new method use two of the N total pins, different pins for the master and the slave. During current calibration, one slave and the master both calibrate at the same time, on different pins.

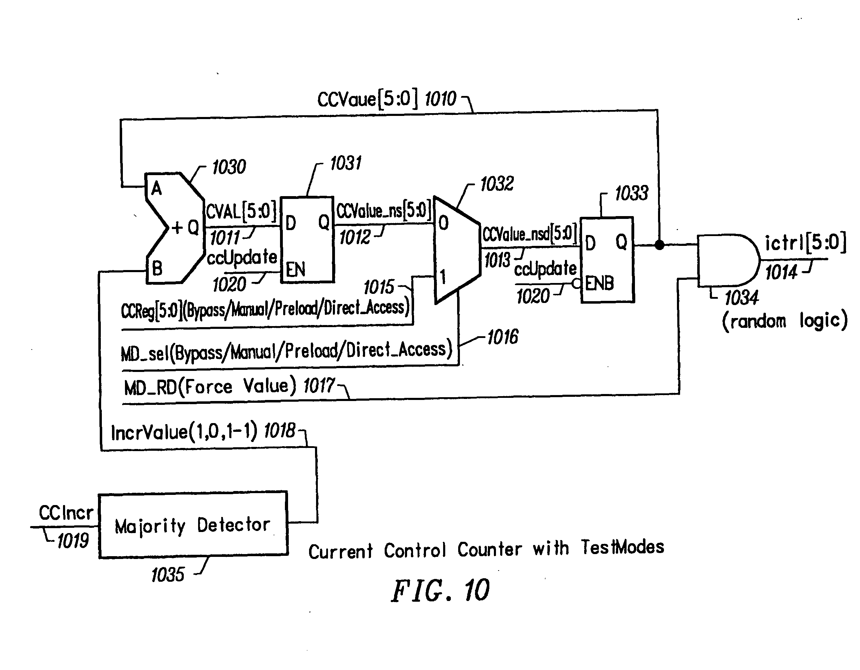

Figure 10 illustrates control and test mode logic that may be used in connection with the invention. The current control counter includes an adder 1030, a master latch 1031, a multiplexer 1032, a slave latch 1033, random logic 1034, and a majority detector 1035. Using the control counter in Figure 10, various modes of operations are possible. In a first mode, the circuitry is placed in an "auto mode" when MD_sel Bypass 1016 is deasserted and MD_RD 1017 is asserted. In the auto mode, CCValue_ns[5:0] 1012 is coupled to CCValue_nsd[5:0] 1013. Each ccUpdate 1020 pulse updates the current control value by one bit based on the Value IncrValue 1018 (which take values of 1, 0, or -1).

During initialization, a series of ccUpdate pulses will drive ictrl[5:] 1014 to approach its equilibrium value. Periodic updates may be done with subsequent ccUpdate pulses at specified intervals.

In a second mode, the circuitry is placed in a "manual mode" when MD_sel Bypass 1016 is asserted and MD_RD 1017 is asserted. In the manual mode, CCValue_nsd[5:0] 1013 is coupled to CCreg[5:0] 1015. At the low phase of ccUpdate, the value of ictrl[5:0] is loaded into CCReg[5:0] 1015. This mode may be used to drive an arbitrary ictrl[5:0] value, or to preload the master-slave flip flop (1033) before entering Auto mode. The same datapath is used during the Direct Access Test mode where test values of ictrl [5:0] are driven by changing CCReg[5:0]. A "mid" value of CCValue[5:0]=100000 may be preloaded at initialization so the equilibrium value is reached with fewer numbers of ccUpdate pulses.

The circuitry may also be placed in a "force mode" when MD_RD 1017 is de-asserted. In the force mode, a specific value may be forced at ictrl[5:0] when MD_RD 1017 is de-asserted. In the preferred embodiment, random logic forces ictrl[5:0]=101111. An alternate embodiment may implement a different forced value or values. This mode is used for testing and calibration.

The majority detector filters the value of CCIncr 1019 and prevents toggling of ictrl[5:0] when the value is within one bit of the settled value. The majority detector takes an even number of samples of Signal CCIncr. The IncrValue 1018 is "1" if the majority of samples are high. The IncrValue 1018 is "-1" if the majority of samples are low. The IncrValue 1018 is "0" if there is no majority.

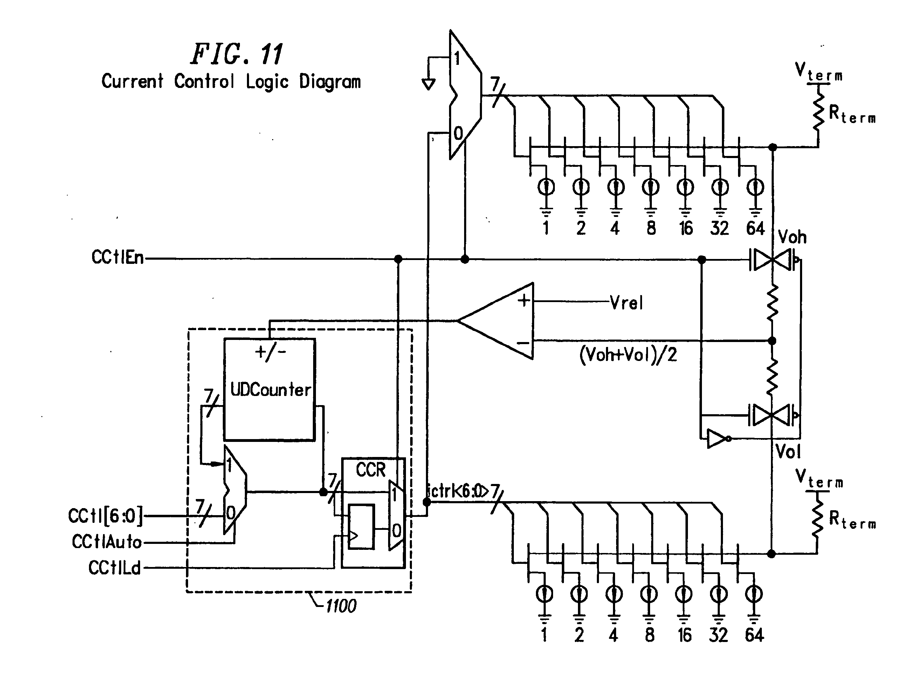

Figure 11 shows another embodiment of current control counter that may be used in accordance with the invention. This implementation uses a seven-bit ictrl value. The circuitry 1100 has three modes of operation. In a first mode, the circuitry is placed in an "auto-acquire mode" when CCtlEn is high and CCtlAuto is high. In the auto-acquire mode, the up-down counter is coupled to ictrl[6:0]. As the up-down counter is incremented or decremented, ictrl[6:0] is changed accordingly, until the equilibrium value of ictrl[6:0] is reached. At this point, the equilibrium value is loaded into CCR with signal CCtlLd, and the current control counter may enter Auto mode.

The circuitry may also be placed in an "auto mode" when CCtlEn is low and CCtlAuto is high. In the auto mode, the register in the CCR block controls the current setting of ictrl[6:0]. In this mode, the up-down counter is also coupled to the CCR register.

The circuitry also has a "manual mode" when CCtlEn is low and CCtlAuto is low. In the manual mode, a seven-bit value CCtl[6:0] is driven or stored into the counter and ictrl[6:0]. This mode is used to set a value into the counter and register that is close to the setting that will actually result in the auto-acquire mode, which cuts down on the time it takes to reach the equilibrium ictrl[6:0] value. This mode may also be used to set the counter and register to a certain value before the auto-acquire mode is entered. This mode may also be used as a test or direct access mode where specific values may be driven onto ictrl[6:0] by changing Cctl[6:0].

The current control circuitry may be implemented with a single output pin to perform current calibration. Both "high" and "low" voltage values are measured from the same pin sequentially with sample-and-hold circuitry. Subsequent processing of these voltage values are averaged with a voltage divider.

In another embodiment, the pin voltage values are measured during normal operation of the RDRAM. Based on data of the DRAM "read" operations, the current control circuitry determines when stable output "high" or "low" voltage patterns are present on the pin. A single pin or multiple pins may be used to measure the pad voltage. Multiple samples and averaging may be performed to filter noise coupling and reflection on the output channel from the stable output "high" and "low" levels. This embodiment has the advantage of requiring no "quiet period" on the channel for current control calibration.

The foregoing description, for purposes of explanation, used specific nomenclature to provide a thorough understanding of the invention. However, it will be apparent to one skilled in the art that the specific details are not required in order to practice the invention. In other instances, well known circuits and devices are shown in block diagram form in order to avoid unnecessary distraction from the underlying invention. Thus, the foregoing descriptions of specific embodiments of the present invention are presented for purposes of illustration and description. They are not intended to be exhaustive or to limit the invention to the precise forms disclosed, obviously many modifications and variations are possible in view of the above teachings. The embodiments were chosen and described in order to best explain the principles of the invention and its practical applications, to thereby enable others skilled in the art to best utilize the invention and various embodiments with various modifications as are suited to the particular use contemplated. It is intended that the scope of the invention be defined by the following claims and their equivalents.

**Claims**

1. A method of operation of an integrated circuit memory device comprising:

   receiving a command that specifies a calibration mode; while in the calibration mode, calibrating a voltage swing level to produce a calibrated voltage swing level, wherein calibrating includes:

   driving a signal having an amount of voltage swing onto a first signal line to produce a voltage level (Vout); and
   adjusting the amount of voltage swing of the signal based on a comparison between a reference voltage level (Vref) and the voltage level (Vout) produced by driving the signal; and
   exiting the calibration mode, wherein, upon exiting the calibration mode, the integrated circuit memory device is operable to drive data onto the first signal line in accordance with the calibrated voltage swing level.

2. The method of claim 1, wherein calibrating is performed concurrently with a memory refresh operation.

3. The method of one of claims 1 or 2, wherein the command that specifies the calibration mode is a register read command,

4. The method of one of the proceeding claims, wherein calibrating is performed during initialization of the integrated circuit memory device, and wherein the method further comprises periodically updating the calibrated voltage swing level after initialization.

5. The method of one of the proceeding claims, further including:

   actively coupling a comparator (125) to the first signal line during the calibration mode; when the comparator (125) is coupled to the first signal line, calibrating the voltage swing level by using the comparator (125) to compare the voltage level (Vout) produced by driving the signal onto the first signal line with the reference voltage level (Vref); and
actively isolating the comparator (125) from the first signal line upon exiting the calibration mode.

6. The method of one of the proceeding claims, further including receiving the reference voltage level (Vref) from a source external to the integrated circuit memory device.

7. The method of one of the proceeding claims, further including generating the reference voltage level (Vref) using a reference voltage generator disposed internally within the integrated circuit memory device.

8. The method of one of the proceeding claims, wherein the amount of voltage swing is represented by a code held in a counter (115), wherein adjusting the amount of voltage swing further comprises updating the code.

9. The method of claim 8, wherein adjusting the amount of voltage swing includes activating a number of output driver transistors based on the code.

10. The method of one of the proceeding claims, wherein the voltage level that is derived from the amount of voltage swing is derived by dividing between a predetermined voltage level and a voltage swing potential corresponding to the amount of voltage swing generated when the signal is driven onto the first signal line.

11. A method of operation of an integrated circuit memory device, the method comprising:

   during a memory refresh period, calibrating a voltage swing characteristic of an output driver (107, 111) of the integrated circuit memory device, wherein calibrating includes;
   driving a signal onto an external signalling path (VOH, VOL); and
   adjusting an amount of voltage swing of the output driver (107, 111) based on a comparison between a reference voltage level (Vref) and a voltage level (Vout) produced by driving the signal.

12. The method of claim 11, wherein adjusting the amount of voltage swing of the output driver (107, 111) includes:

   adjusting the amount of voltage swing in a first direction when the voltage level (Vout) exceeds the reference voltage level (Vref); and
   adjusting the amount of voltage swing in a second direction when the reference voltage level (Vref) exceeds the voltage level (Vout).

**13.** The method of claim 11 or 12, wherein the voltage swing characteristic of the output driver (107, 111) is calibrated periodically.

**14.** The method of one of claims 11 -13, further including receiving a command that instructs the integrated circuit memory device to calibrate the voltage swing characteristic.

**15.** The method of one of claims 11 - 14, wherein adjusting the amount of voltage swing further includes:

actively coupling a comparator (125) to a signal line of the signalling path;
comparing the voltage level (Vout) with the reference voltage level (Vref) using the comparator (125) coupled to the signal line; and
actively isolating the comparator (125) from the signal line upon exiting the calibration mode.

**16.** The method of claim 15, wherein adjusting the amount of voltage swing further includes deriving the voltage level (Vout) by dividing between a predetermined voltage level and a voltage swing potential produced by driving the signal.

**17.** The method of one of claims 11 - 16, further including receiving the reference voltage level (Vref).

**18.** The method of one of claims 11 - 17, further including generating the reference voltage level (Vref) within the integrated circuit memory device.

**19.** The method of one of claims 11 to 18, further including storing a digital value in a register, wherein the digital value represents the amount of voltage swing of the output driver (107,111).

**20.** An integrated circuit memory device that is operable to calibrate a driver output voltage swing characteristic during a memory refresh period, the integrated circuit memory device comprising:

a first output driver (107) to drive a signal onto a first external signal line (VOH); and
an adjustment circuit (104, 125), coupled to the first output driver (107), to adjust an amount of voltage swing of the first output driver (107) based on a comparison between a reference voltage level (Vref) and a voltage level (Vout) produced by driving the signal.

**21.** The integrated circuit memory device of claim 20, wherein:

the amount of voltage swing is adjusted in a first direction when the voltage level (Vout) exceeds the reference voltage level (Vref); and

the amount of voltage swing is adjusted in a second direction when the reference voltage level (Vref) exceeds the voltage level (Vout).

**22.** The integrated circuit memory device of one of claims 20 or 21,
wherein the adjustment circuit (104, 125) includes a comparator (125) to compare the reference voltage level (Vref) and the voltage level (Vout) produced by driving the signal.

**23.** The integrated circuit memory device of one of claims 20 to 22, further including a reference voltage generator, coupled to the comparator (125), to generate the reference voltage level (Vref).

**24.** The integrated circuit memory device of one of claims 20 to 23,
wherein the reference voltage level (Vref) is received from a source external to the integrated circuit memory device.

**25.** The integrated circuit memory device of one of claims 20 to 24,
further including a voltage divider (104) coupled to the first external signal line (VOH) and the first output driver (107), to produce the voltage level (Vout) based on the amount of voltage swing generated, wherein the voltage level (Vout) is determined based on a ratio of resistors of the voltage divider (104).

**26.** The integrated circuit memory device of claim 25, further including a second output driver (111) coupled to a second external signal line (VOL), wherein the voltage divider (104) incudes a first end (vhi) and a second end (vlow), wherein the first end (vhi) is coupled to the first external signal line (VOH) and the second end (vlow) is coupled to the second external signal line (VOL).

**27.** The integrated circuit memory device of one of claims 20 - 26,
further comprising a counter (115) coupled to the adjustment circuit (104, 125) and the first output driver (107), wherein the amount of voltage swing is determined by a code held in the counter (115), wherein the code is adjusted based on the comparison between the reference voltage level (Vref) and the voltage level (Vout) produced by diving the signal.

**28.** The integrated circuit memory device of claim 27, wherein the first output driver (107) includes a plurality of transistors, wherein the signal is driven onto the first external signal line (VOH) by activating a number of transistors of the plurality of transistors, wherein the number of transistors activated is determined by the code.

**29.** The integrated circuit memory device of one of claims 20 - 28,
wherein the first output driver (107) includes a plurality of transistors, wherein the amount of voltage swing of the first output driver (107) is determined by a number of transistors of the plurality of transistors activated.

**30.** The integrated circuit memory device of claim 20, further comprising
an isolation circuit (120) coupled to the driver circuit (107, 111) and the adjustment circuit (104, 125), the isolation circuit (120) to isolate the adjustment circuit (104, 125) from the driver circuit (107, 111) such that the driver circuit (107, 111) is operable to drive data onto the external signal line (VOH, VOL) after the amount of voltage swing of the driver circuit (107, 111) has been calibrated.

**31.** The integrated circuit memory device of claim 30, wherein the adjustment circuit (104, 125) includes:

means for comparing (125) the voltage level (Vout) produced by driving the signal and the reference voltage level (Vref);
voltage dividing means (107, 111) to produce the voltage level (Vout) based on the amount of voltage swing of the driver circuit (107, 111); and counting means (115) for storing a code representative of the amount of voltage swing, wherein the code is adjusted in response to the comparison between the voltage level (Vout) and the reference voltage level (Vref).

**32.** The integrated circuit memory device of claim 30 or 31, wherein the amount of voltage swing is calibrated during a memory refresh operation.

**33.** The integrated circuit memory device of one of claims 30 - 32, wherein the amount of voltage swing of the driver circuit (107, 111) is calibrated periodically.

**34.** The integrated circuit memory device of one of claims 30 - 33, wherein the driver circuit (107, 111) includes a transistor having an effective width that is configured to adjust the amount of voltage swing of the output driver (107, 111).

**35.** The integrated circuit memory device of one of claims 30 - 34, wherein the amount of voltage swing is represented by a code held in a counter (115) and wherein the width of the transistor is configured based on the code, and wherein the code is adjusted based on the comparison between the reference voltage level (Vref) and the voltage level (Vout) derived from driving the signal.

**36.** The integrated circuit memory device of one of claims 30 - 35, wherein the-driver circuit (107, 111) includes a first output driver (107) and a second output driver (111), wherein the first output driver (107) is coupled to the first external signal line (VOH) and the second output driver (111) is coupled to a second external signal line (VOL), and wherein the adjustment circuit (104, 125) includes a voltage divider (104) coupled to the first and second external signal lines (VOH, VOL), wherein the voltage level (Vout) produced by the driver circuit (107, 111) driving the signal is based on a ratio of resistors of the voltage divider (104).

**37.** The integrated circuit memory device of one of claims 30 - 36, wherein the adjustment circuit (104, 125) includes a comparator (125) to compare the reference voltage level (Vref) and the voltage level (Vout) produced by driving the signal.

**38.** The integrated circuit memory device of one of claims 30 - 37, wherein
the amount of voltage swing is adjusted in a first direction when the voltage level (Vout) exceeds the reference voltage level (Vref); and
the amount of voltage swing is adjusted in a second direction when the reference voltage level (Vref) exceeds the voltage level (Vout).

**39.** The integrated circuit memory device of one of claims 30 - 38, further including a reference voltage generator, coupled to the comparator (125), to generate the reference voltage level (Vref).

**40.** The integrated circuit memory device of one of claims 30 - 39, wherein the isolation circuit (120) includes a pass gate that actively couples the adjustment circuit (104, 125) to the driver circuit (107, 111) in response to a command that specifies that the amount of voltage swing is to be calibrated.

**Patentansprüche**

**1.** Verfahren zum Betrieb einer integrierten Schaltungsspeichervorrichtung mit:

Empfangen eines Befehles, der einen Kalibrierungsmodus spezifiziert; während des Kalibrierungsmodus, Kalibrieren eines Spannungshubpegels zum Erzeugen eines kalibrierten Spannungshubpegels, wobei das Kalibrieren umfasst:

Treiben eines Signals, welches einen Betrag eines Spannungshubes aufweist, auf eine erste Signalleitung zum Erzeugen eines Spannungspegels (Vout); und

Anpassen des Betrages eines Spannungshubes des Signals basierend auf einem Vergleich zwischen einem Referenzspannungspegel (Vref) und dem Spannungspegel (Vout), der durch das Treiben des Signals erzeugt ist; und
Beenden des Kalibrierungsmodus, wobei bei Beenden des Kalibrierungsmodus die integrierte Schaltungsspeichervorrichtung in der Lage ist, Daten auf die erste Signalleitung gemäß dem kalibrierten Spannungshubpegel zu treiben.

2. Verfahren nach Anspruch 1, wobei ein Kalibrieren gleichzeitig zu einem Speicherauffrischungsbetrieb durchgeführt wird.

3. Verfahren nach einem von Ansprüchen 1 oder 2, wobei der Befehl, der den Kalibrierungsmodus spezifiziert, ein Registerlesebefehl ist.

4. Verfahren nach einem der vorstehenden Ansprüche, wobei ein Kalibrieren während einer Initialisierung der integrierten Schaltungsspeichervorrichtung durchgeführt wird, und wobei das Verfahren ferner ein periodisches Aktualisieren des kalibrierten Spannungshubpegels nach Initialisierung aufweist.

5. Verfahren nach einem der vorstehenden Ansprüche, ferner mit:

aktivem Koppeln eines Komparators (125) mit der ersten Signalleitung während des Kalibrierungsmodus; wenn der Komparator (125) mit der ersten Signalleitung gekoppelt ist, Kalibrieren des Spannungshubpegels durch Verwenden des Komparators (125) zum Vergleichen des Spannungspegels (Vout), der durch Treiben des Signals auf die erste Signalleitung erzeugt ist, mit dem Referenzspannungspegel (Vref); und
aktivem Isolieren des Komparators (125) von der ersten Signalleitung bei Beenden des Kalibrierungsmodus.

6. Verfahren nach einem der vorstehenden Ansprüche, ferner mit einem Empfangen des Referenzspannungspegels (Vref) von einer Quelle, die extern zu der integrierten Schaltungsspeichervorrichtung ist.

7. Verfahren nach einem der vorstehenden Ansprüche, ferner mit einem Generieren des Referenzspannungspegels (Vref) unter Verwendung eines Referenzspannungsgenerators, der intern zu der integrierten Schaltungsspeichervorrichtung angeordnet ist.

8. Verfahren nach einem der vorstehenden Ansprüche, wobei der Betrag eines Spannungshubes durch einen Code repräsentiert ist, der in einem Zähler (115) gehalten wird, wobei ein Anpassen des Betrages eines Spannungshubes ferner ein Aktualisieren des Codes aufweist.

9. Verfahren nach Anspruch 8, wobei ein Anpassen des Betrages eines Spannungshubes ein Aktivieren einer Anzahl von Ausgangstreibertransistoren basierend auf dem Code aufweist.

10. Verfahren nach einem der vorstehenden Ansprüche, wobei der Spannungspegel, der von dem Betrag eines Spannungshubs abgeleitet ist, durch Teilen zwischen einem vorbestimmten Spannungspegel und einem Spannungshubpotential abgeleitet ist, welches dem Betrag eines Spannungshubs entspricht, welcher generiert ist, wenn das Signal auf die erste Signalleitung getrieben wird.

11. Verfahren zum Betrieb einer integrierten Schaltungsspeichervorrichtung, wobei das Verfahren aufweist:

während eines Speicherauffrischungszeitraumes, Kalibrieren einer Spannungshubcharakteristik eines Ausgangstreibers (107, 111) der integrierten Schaltungsspeichervorrichtung, wobei das Kalibrieren aufweist:

Treiben eines Signals auf einen externen Signalweg (VOH, VOL); und
Anpassen eines Betrages eines Spannungshubes des Ausgangstreibers (107, 111) basierend auf einem Vergleich zwischen einem Referenzspannungspegel (Vref) und einem Spannungspegel (Vout), der durch Treiben des Signals erzeugt ist.

12. Verfahren nach Anspruch 11, wobei ein Anpassen des Betrages eines Spannungshubes des Ausgangstreibers (107, 111) aufweist:

Anpassen des Betrages eines Spannungshubes in einer ersten Richtung, wenn der Spannungspegel (Vout) den Referenzspannungspegel (Vref) übersteigt; und
Anpassen des Betrages eines Spannungshubes in einer zweiten Richtung, wenn der Referenzspannungspegel (Vref) den Spannungspegel (Vout) übersteigt.

13. Verfahren nach Anspruch 11 oder 12, wobei die Spannungshubcharakteristik des Ausgangstreibers (107, 111) periodisch kalibriert wird.

14. Verfahren nach einem von Ansprüchen 11 bis 13, ferner mit einem Empfangen eines Befehles, der die integrierte Schaltungsspeichervorrichtung anweist, die Spannungshubcharakteristik zu kalibrieren.

15. Verfahren nach einem von Ansprüchen 11 bis 14, wobei ein Anpassen des Betrages eines Spannungshubes ferner aufweist:

aktives Koppeln eines Komparators (125) mit einer Signalleitung des Signalweges;
Vergleichen des Spannungspegels (Vout) mit dem Referenzspannungspegel (Vref) unter Verwendung des Komparators (125), der mit der Signalleitung gekoppelt ist; und
aktives Isolieren des Komparators (125) von der Signalleitung bei Beenden des Kalibrierungsmodus.

16. Verfahren nach Anspruch 15, wobei ein Anpassen des Betrages eines Spannungshubes ferner ein Ableiten des Spannungspegels (Vout) durch Teilen zwischen einem vorbestimmten Spannungspegel und einem Spannungshubpotential aufweist, welches durch Treiben des Signals erzeugt ist.

17. Verfahren nach einem von Ansprüchen 11 bis 16, ferner mit einem Empfangen des Referenzspannungspegels (Vref).

18. Verfahren nach einem von Ansprüchen 11 bis 17, ferner mit einem Generieren des Referenzspannungspegels (Vref) innerhalb der integrierten Schaltungsspeichervorrichtung.

19. Verfahren nach einem von Ansprüchen 11 bis 18, ferner mit einem Speichern eines digitalen Wertes in einem Register, wobei der digitale Wert den Betrag eines Spannungshubs des Ausgangstreibers (107, 111) repräsentiert.

20. Integrierte Schaltungsspeichervorrichtung, die zum Kalibrieren einer Treiberausgangsspannungshubcharakteristik während eines Speicherauffrischungszeitraumes geeignet ist, wobei die integrierte Schaltungsspeichervorrichtung aufweist:

einen ersten Ausgangstreiber (107) zum Treiben eines Signals auf eine erste externe Signalleitung (VOH); und
eine Anpassungsschaltung (104, 125), die mit dem ersten Ausgangstreiber (107) gekoppelt ist, zum Anpassen eines Betrages eines Spannungshubes des ersten Ausgangstreibers (107) basierend auf einem Vergleich zwischen einem ersten Referenzspannungspegel (Vref) und einem Spannungspegel (Vout), der durch Treiben des Signals erzeugt ist.

21. Integrierte Schaltungsspeichervorrichtung nach Anspruch 20, wobei:

der Betrag eines Spannungshubes in einer ersten Richtung angepasst wird, wenn der Spannungspegel (Vout) den Referenzspannungspegel (Vref) übersteigt: und
der Betrag eines Spannungshubes in einer zweiten Richtung angepasst wird, wenn der Referenzspannungspegel (Vref) den Spannungspegel (Vout) übersteigt.

22. Integrierte Schaltungsspeichervorrichtung nach einem von Ansprüchen 20 oder 21, wobei die Anpassungsschaltung (104, 125) einen Komparator (125) zum Vergleichen des Referenzspannungspegels (Vref) und des Spannungspegels (Vout) aufweist, der durch Treiben des Signals erzeugt ist.

23. Integrierte Schaltungsspeichervorrichtung nach einem von Ansprüchen 20 oder 22, ferner mit einem Referenzspannungsgenerator, der mit dem Komparator (125) gekoppelt ist, zum Generieren des Referenzspannungspegels (Vref).

24. Integrierte Schaltungsspeichervorrichtung nach einem von Ansprüchen 20 oder 23, wobei der Referenzspannungspegel (Vref) von einer Quelle empfangen wird, die extern zu der integrierten Schaltungsspeichervorrichtung ist.

25. Integrierte Schaltungsspeichervorrichtung nach einem von Ansprüchen 20 oder 24, ferner mit einem Spannungsteiler (104), der mit der ersten externen Signalleitung (VOH) und dem ersten Ausgangstreiber (107) gekoppelt ist, zum Erzeugen des Spannungspegels (Vout) basierend auf dem Betrag eines Spannungshubes, der generiert ist, wobei der Spannungspegel (Vout) basierend auf einem Verhältnis von Widerständen des Spannungsteilers (104) bestimmt ist.

26. Integrierte Schaltungsspeichervorrichtung nach Anspruch 25, ferner mit einem zweiten Ausgangstreiber (111), der mit einer zweiten externen Signalleitung (VOL) gekoppelt ist, wobei der Spannungsteiler (104) ein erstes Ende (vhi) und ein zweites Ende (vlow) aufweist, wobei das erste Ende (vhi) mit der ersten externen Signalleitung (VOH) gekoppelt ist und das zweite Ende (vlow) mit der zweiten externen Signalleitung (VOL) gekoppelt ist.

27. Integrierte Schaltungsspeichervorrichtung nach einem von Ansprüchen 20 bis 26, ferner mit einem Zähler (115), der mit der Anpassungsschaltung (105, 125) und dem ersten Ausgangstreiber (107) gekoppelt ist, wobei der Betrag eines Spannungshubes durch einen Code bestimmt ist, der in dem Zähler (115) gehalten ist, wobei der Code basierend auf dem Vergleich zwischen dem Referenzspannungspegel (Vref) und dem Spannungspegel (Vout) angepasst wird, der durch Treiben des Signals erzeugt ist.

28. Integrierte Schaltungsspeichervorrichtung nach Anspruch 27, wobei der erste Ausgangstreiber (107) eine Vielzahl von Transistoren aufweist, wobei das Signal auf die erste externe Signalleitung (VOH) durch Aktivieren einer Anzahl von Transistoren der Vielzahl von Transistoren getrieben wird, wobei die Anzahl von Transistoren, die aktiviert sind, durch den Code bestimmt ist.

29. Integrierte Schaltungsspeicharvorrichtung nach einem von Ansprüchen 20 bis 28, wobei der erste Ausgangstreiber (107) eine Vielzahl von Transistoren aufweist, wobei der Betrag eines Spannungshubes des ersten Ausgangstreibers (107) durch eine Anzahl von Transistoren der Vielzahl von Transistoren bestimmt ist, die aktiviert sind.

30. Integrierte Schaltungsspeichervorrichtung nach Anspruch 20, ferner mit einer Isolierungsschaltung (120), die mit der Treiberschaltung (107, 111) und der Anpassungsschaltung (104, 125) gekoppelt ist, wobei die Isolierungsschaltung (120) zum Isolieren der Anpassungsschaltung (104, 125) von der Treiberschaltung (107, 111) ausgestaltet ist, so dass die Treiberschaltung (107, 111) zum Treiben von Daten auf die externe Signalleitung (VOH, VOL) geeignet ist, nachdem der Betrag eines Spannungshubes des Ausgangstreibers (107, 111) kalibriert worden ist.

31. Integrierte Schaltungsspeichervorrichtung nach Anspruch 30, wobei die Anpassungsschaltung (104, 125) aufweist:

Mittel zum Vergleichen (125) des Spannungspegels (Vout), der durch Treiben des Signals erzeugt ist, und des Referenzspannungspegels (Vref);
Spannungsteilungsmittel (107, 111) zum Erzeugen des Spannungspegels (Vout) basierend auf dem Betrag eines Spannungshubes der Treiberschaltung (107, 111); und
Zählmittel (115) zum Speichern eines Codes, der den Betrag eines Spannungshubes repräsentiert, wobei der Code in Antwort auf den Vergleich zwischen dem Spannungspegel (Vout) und dem Referenzspannungspegel (Vref) angepasst wird.

32. Integrierte Schaltungsspeichervorrichtung nach Anspruch 30 oder 31, wobei der Betrag eines Spannungshubs während eines Speicherauffrischungsbetriebes kalibriert wird.

33. Integrierte Schaltungsspeichervorrichtung nach einem von Ansprüchen 30 bis 32, wobei der Betrag eines Spannungshubes der Treiberschaltung (107, 111) periodisch kalibriert wird.

34. Integrierte Schaltungsspeichervorrichtung nach einem von Ansprüchen 30 bis 33, wobei die Treiberschaltung (107, 111) einen Transistor mit einer effektive Breite aufweist, der konfiguriert ist, um den Betrag eines Spannungshubes des Ausgangstreibers (107, 111) anzupassen.

35. Integrierte Schaltungsspeichervorrichtung nach einem von Ansprüchen 30 bis 34, wobei der Betrag eines Spannungshubes durch einen Code repräsentiert wird, der in einem Zähler (115) gehalten wird, und wobei die Breite des Transistors basierend auf dem Code konfiguriert ist, und wobei der Code basierend auf dem Vergleich zwischen dem Referenzspannungspegel (Vref) und dem Spannungspegel (Vout) angepasst wird, der vom Treiben des Signals abgeleitet ist.

36. Integrierte Schaltungsspeichervorrichtung nach einem von Ansprüchen 30 bis 35, wobei die Treiberschaltung (107, 111) einen ersten Ausgangstreiber (107) und einen zweiten Ausgangstreiber (111) aufweist, wobei der erste Ausgangstreiber (107) mit der ersten externen Signalleitung (VOH) gekoppelt ist und der zweite Ausgangstreiber (111) mit einer zweiten externen Signalleitung (VOL) gekoppelt ist, und wobei die Anpassungsschaltung (104, 125) einen Spannungsteiler (104) aufweist, der mit den ersten und zweiten externen Signalleitungen (VOH, VOL) gekoppelt ist, wobei der Spannungspegel (Vout), der durch die Treiberschaltung (107, 111) erzeugt ist, die das Signal treibt, auf einem Verhältnis von Widerständen des Spannungsteilers (104) basiert.

37. Integrierte Schaltungsspeichervorrichtung nach einem von Ansprüchen 30 bis 36, wobei die Anpassungsschaltung (104, 125) einen Komparator (125) zum Vergleichen des Referenzspannungspegels (Vref) und des Spannungspegels (Vout) aufweist, der durch Treiben des Signals erzeugt ist.

38. Integrierte Schaltungsspeichervorrichtung nach einem von Ansprüchen 30 bis 37, wobei:

der Betrag eines Spannungshubes in einer ersten Richtung angepasst wird, wenn der Spannungspegel (Vout) den Referenzspannungspegel (Vref) übersteigt; und
der Betrag eines Spannungshubes in einer zweiten Richtung angepasst wird, wenn der Referenzspannungspegel (Vref) den Spannungspegel (Vout) übersteigt.

**39.** Integrierte Schaltungsspeichervorrichtung nach einem von Ansprüchen 30 bis 38, ferner mit einem Referenzspannungsgenerator, der mit dem Komparator (125) gekoppelt ist, zum Generieren des Referenzspannungspegels (Vref).

**40.** Integrierte Schaltungsspeichervorrichtung nach einem von Ansprüchen 30 bis 39, wobei die Isolierungsschaltung (120) ein Durchlassgatter aufweist, welches aktiv die Anpassungsschaltung (104, 125) mit der Treiberschaltung (107, 111) in Antwort auf einen Befehl koppelt, der spezifiziert, dass der Betrag eines Spannungshubes zu kalibrieren ist.

## Revendications

**1.** Procédé de fonctionnement d'un dispositif de mémoire à circuits intégrés comportant ;
la réception d'une commande qui spécifie un mode de calibrage ; tout en calibrant, dans le mode de calibrage, un niveau d'excursion de tension pour produire un niveau d'excursion de tension calibré, dans lequel le calibrage comprend :

la commande d'un signal possédant une quantité d'excursion de tension sur une première ligne signal pour produire un niveau de tension (Vout) ; et
le réglage de la quantité d'excursion de tension du signal en fonction d'une comparaison entre un niveau de tension de référence (Vref) et le niveau de tension (Vout) produit par la commande du signal ; et
la sortie du mode de calibrage, dans lequel, lors de la sortie du mode de calibrage, le dispositif de mémoire à circuits intégrés permet de commander des données sur la première ligne signal conformément au niveau d'excursion de tension calibré.

**2.** Procédé selon la revendication 1, dans lequel le calibrage est effectué concurremment avec une opération de rafraîchissement de mémoire.

**3.** Procédé selon l'une des revendications 1 ou 2, dans lequel la commande qui spécifie le mode de calibrage est d'une commande de lecture de registre.

**4.** Procédé selon l'une des revendications précédentes, dans lequel le calibrage est effectué pendant l'initialisation du dispositif de mémoire à circuits intégrés, et dans lequel le procédé comporte en outre la mise à jour périodique du niveau d'excursion de tension calibré après l'initialisation.

**5.** Procédé selon l'une des revendications précédentes, comportant en outre :

le couplage actif d'un comparateur (125) à la première ligne signal pendant le mode de calibrage ; lorsque le comparateur (125) est couplé à la première ligne signal, calibrer le niveau d'excursion de tension en utilisant le comparateur (125) pour comparer le niveau de tension (Vout) produit en commandant le signal sur la première ligne signal avec le niveau de tension de référence (Vref) ; et
l'isolement actif du comparateur (125) de la première ligne signal lors de la sortie du mode de calibrage.

**6.** Procédé selon l'une des revendications précédentes, comprenant en outre la réception du niveau de tension de référence (Vref) depuis une source externe au dispositif de mémoire à circuits intégrés.

**7.** Procédé selon l'une des revendications précédentes, comprenant en outre la génération du niveau de tension de référence (Vref) en utilisant un générateur de tension de référence disposé intérieurement dans le dispositif de mémoire à circuits intégrés.

**8.** Procédé selon l'une des revendications précédentes, dans lequel la quantité d'excursion de tension est représentée par un code conservé dans un compteur (115), dans lequel le réglage de la quantité d'excursion de tension comporte en outre la mise à jour du code.

**9.** Procédé selon la revendication 8, dans lequel le réglage de la quantité d'excursion de tension comprend l'activation d'un nombre de transistors de commande de sortie en fonction du code.

**10.** Procédé selon l'une des revendications précédentes, dans lequel le niveau de tension qui est dérivé de la quantité d'excursion de tension est dérivé en divisant un niveau de tension prédéterminé et un potentiel d'excursion de tension correspondant à la quantité d'excursion de tension générée lorsque le signal est commandé sur la première ligne signal.

**11.** Procédé de fonctionnement d'un dispositif de mémoire à circuits intégrés, procédé comportant :

pendant une période de rafraîchissement de mémoire, le calibrage d'une caractéristique d'excursion de tension d'une commande de sortie (107, 111) du dispositif de mémoire à circuits intégrés, dans lequel le calibrage comprend :

la commande de signal sur un trajet de signalisation externe (VOH, VOL) ; et
le réglage d'une quantité d'excursion de tension de la commande de sortie (107, 111) en fonction d'une comparaison entre un niveau de tension de référence (Vref) et un niveau de tension (Vout) produit en commandant le signal.

12. Procédé selon la revendication 11, dans lequel le réglage de la quantité d'excursion de tension de la commande de sortie (107, 111) comprend :

le réglage de la quantité d'excursion de tension dans une première direction lorsque le niveau de tension (Vout) dépasse le niveau de tension de référence (Vref) ; et
le réglage de la quantité d'excursion de tension dans une seconde direction lorsque le niveau de tension de référence (Vref) dépasse le niveau de tension (Vout).

13. Procédé selon la revendication 11 ou 12, dans lequel la caractéristique d'excursion de tension de la commande de sortie (107, 111) est calibrée périodiquement.

14. Procédé selon l'une des revendications 11-13, comportant en outre la réception d'une commande qui ordonne au dispositif de mémoire à circuits intégrés de calibrer la caractéristique d'excursion de tension.

15. Procédé selon l'une des revendications 11-14, dans lequel le réglage de la quantité d'excursion de tension comporte en outre :

le couplage actif d'un comparateur (125) sur une ligne signal du trajet de signalisation ;
la comparaison du niveau de tension (Vout) au niveau de tension de référence (Vref) en utilisant le comparateur (125) couplé la ligne signal ; et
l'isolement actif du comparateur (125) de la ligne signal lors de la sortie du mode de calibrage.

16. Procédé selon la revendication 15, dans lequel le réglage de la quantité d'excursion de tension comporte en outre la dérivation du niveau de tension (Vout) en séparant un niveau de tension prédéterminée et un potentiel d'excursion de tension produite en commandant le signal.

17. Procédé selon l'une des revendications 11-16, comportant en outre la réception du niveau de tension de référence (Vref).

18. Procédé selon l'une des revendications 11-17, comportant en outre la génération du niveau de tension de référence (Vref) à l'intérieur du dispositif de mémoire à circuits intégrés.

19. Procédé selon l'une des revendications 11 à 18, comportant en outre la mémorisation d'une valeur numérique dans un registre, dans lequel la valeur numérique représente la quantité d'excursion de tension de la commande de sortie (107, 111).

20. Dispositif de mémoire circuits intégrés qui permet de calibrer une caractéristique d'excursion de tension de sortie de commande pendant une période de rafraîchissement de mémoire, le dispositif de mémoire à circuits intégrés comportant :

une première commande de sortie (107) pour commander un signal sur une première ligne signal externe (VOH) ; et
un circuit de réglage (104, 125), couplé à la première commande de sortie (107), pour régler une quantité d'excursion de tension de la première commande de sortie (107) en fonction d'une comparaison entre un niveau de tension de référence (Vref) et un niveau de tension (Vout) produit en commandant le signal.

21. Dispositif de mémoire à circuits intégrés selon la revendication 20, dans lequel :

la quantité d'excursion de tension est réglée dans une première direction lorsque le niveau de tension (Vout) dépasse le niveau de tension de référence (Vref) ; et
la quantité d'excursion de tension est réglée dans une seconde direction lorsque le niveau de tension de référence (Vref) dépasse le niveau de tension (Vout).

22. Dispositif de mémoire à circuits intégrés selon l'une des revendications 20 ou 21, dans lequel le circuit de réglage (104, 125) comporte un comparateur (25) pour comparer le niveau de tension de référence (Vref) et le niveau de tension (Vout) produit en commandant le signal.

23. Dispositif de mémoire à circuits intégrés selon l'une des revendications de 20 à 22, comportant en outre un générateur de tension de référence, couplé au comparateur (125), pour générer le niveau de tension de référence (Vref).

24. Dispositif de mémoire à circuits intégrés selon l'une des revendications de 20 à 23, dans lequel le niveau de tension de référence (Vref) est reçu depuis une source externe au dispositif de mémoire à circuits intégrés.

25. Dispositif de mémoire à circuits intégrés selon l'une des revendications de 20 à 24, comportant en outre un diviseur de tension (104) couplé à la première ligne signal externe (VOH) et à la première commande de sortie (107), pour produire le niveau de tension (Vout) en fonction de la quantité d'excursion de tension générée, dans lequel le niveau de tension (Vout) est déterminé en fonction de rapport de résistances du diviseur de tension (104).

26. Dispositif de mémoire circuits intégrés selon la revendication 25, comportant en outre une seconde commande de sortie (111) couplée à une seconde ligne signal externe (VOL), dans lequel le diviseur de tension (104) comprend une première extrémité (vhi) et une seconde extrémité (vlow), dans lequel la première extrémité (vhi) est couplée la première ligne signal externe (VOH) et la seconde extrémité (vlow) est couplée à la seconde ligne signal externe (VOL).

27. Dispositif de mémoire circuits intégrés selon l'une des revendications 20-26, comportant en outre un compteur (115) couplé au circuit de réglage (104, 125) et à la première commande de sortie (107), dans lequel la quantité d'excursion de tension est déterminée par un code conservé dans le compteur (115), dans lequel le code est réglé en fonction de la comparaison entre le niveau de tension de référence (Vref) et le niveau de tension (Vout) produit en commandant le signal.

28. Dispositif de mémoire à circuits intégrés selon la revendication 27, dans lequel la première commande de sortie (107) comprend une pluralité de transistors, dans lequel le signal est commandé sur la première ligne signal externe (VOH) en activant un nombre de transistors parmi la pluralité de transistors, dans lequel le nombre de transistors activés est déterminé par le code.

29. Dispositif de mémoire à circuits intégrés selon l'une des revendications 20-28, dans lequel la première commande de sortie (107) comprend une pluralité de transistors, dans lequel la quantité d'excursion de tension de la première commande de sortie (107) est déterminée par un certain nombre de transistors parmi la pluralité de transistors activés.

30. Dispositif de mémoire à circuits intégrés selon la revendication 20, comportant en outre un circuit d'isolation (120) couplé au circuit de commande (107, 111) et au circuit de réglage (104, 125), le circuit d'isolation (120) pour isoler le circuit de réglage (104, 125) du circuit de commande (107, 111) de sorte que le circuit de commande (107, 111) permet de commander des données sur la ligne signal externe (VOH, VOL) après que la quantité d'excursion de tension du circuit de commande (107, 111) a été calibrée,

31. Dispositif de mémoire circuits intégrés selon la revendication 30, dans lequel le circuit de réglage (104, 125) comporte :

des moyens pour comparer (125) le niveau de tension (Vout) produit en commandant le signal et le niveau de tension de référence (Vref) ;
des moyens diviseurs de tension (107, 111) pour produire le niveau de tension (Vout) en fonction de la quantité d'excursion de tension du circuit de commande (107, 111) ; et
un moyen de comptage (115) pour mémoriser un code représentant la quantité d'excursion de tension, dans lequel le code est réglé en réponse la comparaison entre le niveau de tension (Vout) et le niveau de tension de référence (Vref).

32. Dispositif de mémoire à circuits intégrés selon la revendication 30 ou 31, dans lequel la quantité d'excursion de tension est calibrée pendant une opération de rafraîchissement de mémoire.

33. Dispositif de mémoire à circuits intégrés selon l'une des revendications 30-32, dans lequel la quantité d'excursion de tension du circuit de commande (107, 111) est calibrée périodiquement.

34. Dispositif de mémoire circuits intégrés selon l'une des revendications 30-33, dans lequel le circuit de commande (107, 111) comprend un transistor possédant une largeur effective qui est configurée pour régler la quantité d'excursion de tension de la commande de sortie (107, 111).

35. Dispositif de mémoire à circuits intégrés selon l'une des revendications 30-34, dans lequel la quantité d'excursion de tension est représentée par un code conservé dans un compteur (115) et dans lequel la largeur du transistor est configurée en fonction du code, et dans lequel le code est réglé en fonction de la comparaison entre le niveau de tension de référence (Vref) et le niveau de tension (Vout) dérivé à partir de la commande du signal.

36. Dispositif de mémoire à circuits intégrés selon l'une des revendications 30-35, dans lequel le circuit de commande (107, 111) comprend une première commande de sortie (107) et une seconde commande de sortie (111), dans lequel la première commande de sortie (107) est couplée à la première ligne signal externe (VOH) et la seconde commande de sortie (111) est couplée à une seconde ligne signal externe (VOL), et dans lequel le circuit de réglage (104, 125) comprend un diviseur de tension (104) couplé aux première et seconde lignes signal externes (VOH, VOL), dans lequel le niveau de tension (Vout) produit par le circuit de commande (107, 111) commandant le signal est basé sur un rapport des résistances du diviseur de tension (104).

37. Dispositif de mémoire à circuits intégrés selon l'une des revendications 30-36, dans lequel le circuit de réglage (104, 125) comprend un comparateur (125) pour comparer le niveau de tension de référence (Vref) et le niveau de tension (Vout) produit en commandant le signal.

**38.** Dispositif de mémoire à circuits intégrés selon l'une des revendications 30-37, dans lequel :

la quantité d'excursion de tension est réglée dans une première direction lorsque le niveau de tension (Vout) dépasse le niveau de tension de référence (Vref) ; et
la quantité d'excursion de tension est réglée dans une seconde direction lorsque le niveau de tension de référence (Vref) dépasse le niveau de tension (vout).

**39.** Dispositif de mémoire à circuits intégrés selon l'une des revendications 30-38, comprenant en outre un générateur de tension de référence, couplé au comparateur (125), pour générer le niveau de tension de référence (Vref).

**40.** Dispositif de mémoire à circuits intégrés selon l'une des revendications 30-39, dans lequel le circuit d'isolation (120) comprend une grille de passage qui couple activement le circuit de réglage (104, 125) au circuit de commande (107, 111) en réponse à une commande qui spécifie que la quantité d'excursion de tension doit être calibrée.

FIG. 1
PRIOR ART

Block Diagram of Current Control Circuitry.

FIG. 2

EP 1 048 109 B1

FIG. 3

**FIGURE 4**

FIGURE 5

EP 1 048 109 B1

**FIGURE 6**

**FIGURE 7**

# FIGURE 8

FIG. 9

Current Control Counter with TestModes

*FIG. 10*

*FIG. 11*
Current Control Logic Diagram

**EP 1 048 109 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5254883 A